(19) Europäisches Patentamt
European Patent Office
Office européen des brevets

(11) EP 1 882 983 A1

(12) EUROPEAN PATENT APPLICATION

(43) Date of publication:
30.01.2008 Bulletin 2008/05

(51) Int Cl.:
$G03F\ 7/20$ (2006.01)

(21) Application number: 06117813.3

(22) Date of filing: 25.07.2006

(84) Designated Contracting States:
AT BE BG CH CY CZ DE DK EE ES FI FR GB GR
HU IE IS IT LI LT LU LV MC NL PL PT RO SE SI
SK TR
Designated Extension States:
AL BA HR MK YU

(71) Applicant: Carl Zeiss SMT AG
73447 Oberkochen (DE)

(72) Inventor: Kwan, Yim-Bun Patrick
73431, Aalen (DE)

(74) Representative: Cohausz & Florack
Patent- und Rechtsanwälte
Bleichstrasse 14
40211 Düsseldorf (DE)

(54) **Gravity compensating support for an optical element**

(57) There is provided an optical element module comprising an optical element and a support structure supporting the optical element. The support structure comprises an actuator device and a gravity compensation device. The actuator device is mechanically connected to the optical element and adapted to exert an actuation force on the optical element, the actuation force accelerating the optical element. The gravity compensation device comprises a gravity compensator. The gravity compensator is mechanically connected to the optical element and adapted to exert a gravity compensation force on the optical element when a negative pressure is acting within the gravity compensator. The gravity compensation force counteracts at least a part of the gravitational force acting on the optical element. It will be appreciated here that more than one gravity compensator may be used to fully compensate the gravitational force acting on the optical element.

Fig. 2

EP 1 882 983 A1

## EP 1 882 983 A1

**Description**

<u>BACKGROUND OF THE INVENTION</u>

The invention relates to a support structure for an optical element and an optical element module comprising such a support structure. Furthermore, it relates to a method of supporting an optical element. The invention may be used in the context of photolithography processes for fabricating microelectronic devices, in particular semiconductor devices, or in the context of fabricating devices, such as masks or reticles, used during such photolithography processes.

Due to the ongoing miniaturization of semiconductor devices there is a permanent need for enhanced resolution and accuracy of the systems used for fabricating those semiconductor devices. This need for enhanced resolution and accuracy obviously not only pushes the need for an increased performance of the optical system used in the exposure process it also pushes the need for an increased performance of the auxiliary systems participating in the exposure process, such as the support structure supporting the semiconductor device, e.g. a wafer, to be manufactured. Furthermore, to reliably obtain high-quality semiconductor devices it is not only necessary to provide a system having a high nominal performance. It is also necessary to maintain such a high performance throughout the entire exposure process and over the lifetime of the system.

Thus, there is a clear tendency to actively position an increasing number of the optical elements participating in the exposure process to account for manufacturing tolerances as well as drifts and degradations of the system during operation. Typically, these optical elements have to be actively positioned in more than one degree of freedom (DOF).

Furthermore, there is an increasing demand for higher throughput of the process of manufacturing semiconductor devices. This higher throughput, among others, requires a faster positioning process of the optical elements, for example, faster illumination setting changes, e.g. in a die to die change or a wafer to wafer change. Furthermore, in addition to the faster positioning process, larger positioning ranges are required which may reach up to more than 50 mm.

The demand for increased resolution and the associated demand for increased imaging accuracy obviously drives the need for an actuating mechanism for the optical elements that is as far as possible free of parasitic forces which might otherwise introduce deformations into the optical element to be positioned and, thus, deteriorate imaging accuracy.

Thus, as it is known for example from US 2004/0179192 A1 (Mizuno et al.), the entire disclosure of which is incorporated herein by reference, contactless actuators, such as so-called voice coil actuators or Lorentz actuators, are used to avoid such parasitic forces. However, these contactless actuators typically have the disadvantage that they have to be continuously energized in order to bear the static load resulting from the gravitational force acting on the optical element to be held. Thus, considerable heat is generated at these contactless actuators which in turn may lead to thermally induced deformations that deteriorate imaging accuracy.

As a consequence, the above US 2004/0179192 A1 (Mizuno et al.) proposes to have a passive gravity compensation device that counteracts the gravitational force acting on the optical element to be positioned such that the contactless actuators only have to generate the forces necessary to accelerate and, thus, position the optical element. It is proposed to have one or more passive spring elements, such as coil springs or permanent magnetic springs, bearing the weight of the optical element.

As coil springs multiple coil springs with evenly distributed coils may be used, for example, since they have the advantage of a rather low stiffness and - thanks to the even circumferential distribution of the coils - they do not produce parasitic moments. As permanent magnetic springs magnetic devices may be used as they are known e.g. from US 2004/0212794 A1 (Mizuno), US 2003/0052284 A1 (Hol et al.) and US 2005/0002008 A1 (De Weerdt et al.), the entire disclosure of all of which is incorporated herein by reference.

All these spring elements have a certain stiffness leading to a change in the spring force provided by the spring element upon an excursion of the optical element from a neutral position. This change in the spring force causes the problem that the contactless actuator, in addition to providing the force necessary for accelerating the optical element, has to negotiate the difference between the spring force and the gravitational force acting on the optical element leading to and increased energy consumption of the contactless actuator with the associated heat generation.

Thus, while the known passive spring elements may provide good results for a rather small positioning range of the optical element they have the disadvantage that they are unsuitable for applications with a larger positioning range , e.g. starting from 10 mm and more.

Furthermore, it is known for example from US 2004/0001188 A1 (Janssen et al.), the entire disclosure of which is incorporated herein by reference, to use a pneumatic gravity compensation device for supporting a wafer table, i.e. counteracting the constant gravitational force acting on the wafer table. Here, a gaseous working medium such as air is supplied to a positive pressure chamber defined by a cylinder and a piston slidably mounted therein. The piston is mechanically connected to the wafer table to bear the weight of the wafer table.

Here, the force of the gravity compensation device may be easily kept substantially constant by a simple pressure control. This, in principle, would allow a virtually unlimited positioning range. However, this pneumatic gravity compensation solution as the disadvantage that there is a considerable inertia in the system due to the relatively large mass of gas that has to be supplied to the positive pressure chamber leading to an increase in the reaction time of the system. Furthermore, the relatively large amount of gas to be conveyed leads to considerable internal friction within the gas.

Both effects lead to a noticeable damping effect within the control loop of the pneumatic gravity compensation system limiting the dynamic performance of the system.

A further disadvantage of such a known pneumatic gravity compensation system is the fact that the pressurized gas escapes through the gap between the piston and the cylinder and eventually contaminates the atmosphere surrounding the optical element. Thus, costly measures, such as evacuation lines close to the piston as proposed in the above US 2004/0001188 A1 (Janssen et al.), have to be taken to account for this problem.

### SUMMARY OF THE INVENTION

It is thus an object of the invention to, at least to some extent, overcome the above disadvantages and to provide an optical element module and a support to an optical element, respectively, that may be used for highly dynamic positioning applications with larger positioning ranges, in particular positioning ranges of 10 mm and more.

It is a further object of the invention to increase the available positioning range of an actuating support structure for an optical element by simple means while maintaining the influence of the actuation on the imaging accuracy of the optical element as low as possible.

These objects are achieved according to the invention which is based on the teaching that a highly dynamic gravity compensation allowing increased positioning ranges without deteriorating the imaging accuracy may be achieved by using a negative pressure for generating a force that counteracts the gravitational force acting on the optical element to be supported. The use of the pressure of based gravity compensation, due to the simple pressure control that may be achieved, the gravity compensation force may be easily kept at least close to its optimum value over a virtually unlimited positioning range of the optical element. Since virtually no energy has to be supplied to the system in proximity of the optical element the problem of heat generation and introduction into the optical system under static load conditions is largely avoided.

Furthermore, apart from the simple pressure control that may be achieved, the use of a negative pressure has the advantage that a lower mass of working medium is to be conveyed when positioning the optical element. Thus, a lower inertia and lower internal friction is to be dealt with leading to improved dynamic properties of the system. Furthermore, the use of the negative pressure simply eliminates the contamination problem since there is no material transport through any sealing gap of the gravity compensation device used towards the surroundings of the optical element.

Furthermore, the gravity compensation may be achieved in a simple and space saving manner by implementing a simple cylinder and piston arrangement forming a negative pressure chamber wherein the negative pressure is provided by a suitable negative pressure source. The control keeping the gravity compensation force substantially equal to the gravitational force acting on the optical element during the positioning process may be a simple pressure control. It may be provided, for example, via a pressure sensor providing the actual level of negative pressure to a suitable control device adjusting the negative pressure to a given setpoint value.

It will be appreciated that, with the invention, positioning ranges - i.e. a travel of the optical element from one extreme position to its other extreme position - of more than 10 mm to 30 mm, even more than 50 mm may be achieved at substantially optimized gravity compensation force. This may be done within a very short interval of less than two seconds, even less than one second.

Thus, according to a first aspect of the invention there is provided an optical element module comprising an optical element and a support structure supporting the optical element. The support structure comprises an actuator device and a gravity compensation device. The actuator device is mechanically connected to the optical element and adapted to exert an actuation force on the optical element, the actuation force accelerating the optical element. The gravity compensation device comprises a gravity compensator. The gravity compensator is mechanically connected to the optical element and adapted to exert a gravity compensation force on the optical element when a negative pressure is acting within the gravity compensator. The gravity compensation force counteracts at least a part of the gravitational force acting on the optical element. It will be appreciated here that more than one gravity compensator may be used to fully compensate the gravitational force acting on the optical element.

According to a second aspect of the invention there is provided an optical exposure apparatus for transferring an image of a pattern formed on a mask onto a substrate comprising an illumination system adapted to provide light of a light path, a mask unit located within the light path and adapted to receive the mask, a substrate unit located at an end of the light path and adapted to receive the substrate, an optical projection system located within the light path between the mask location and the substrate location and adapted to transfer an image of the pattern onto the substrate. At least one of the illumination system and the optical projection system comprises an optical element module according do the first aspect of the invention.

According to a third aspect of the invention there is provided a support structure for supporting an optical element comprising an actuator device and a gravity compensation device.
The actuator device is adapted to be mechanically connected to the optical element and to exert an actuation force on the optical element, the actuation force accelerating the optical element. The gravity compensation device comprises a gravity compensator, the gravity compensator being adapted to be mechanically connected to the optical element and to exert a gravity compensation force on the optical element when a negative pressure is acting within the gravity compensator. The gravity compensation force counteracts at least a part of the gravitational force acting on the optical element.

According to a fourth aspect of the invention there is provided a method of supporting an optical element comprising providing an optical element and a gravity compensation device, exerting a gravity compensation force on the optical element via the gravity compensation device, the gravity compensation force counteracting at least a part of the gravitational force acting on the optical element. The exerting the gravity compensation force comprises generating the gravity compensation force using a negative pressure.

It will be appreciated in this context that more than one gravity compensator and gravity compensation force, respectively, may be used to fully compensate the gravitational force acting on the optical element. However, is also possible that the full gravity compensation of the optical element is provided by one single gravity compensator and gravity compensation force, respectively.

Preferably, the above aspects of the invention are used in the context of microlithography applications. However, it will be appreciated that the invention may also be used in any other type of optical exposure process or any other type of supporting an element being either an optical or not.

Further embodiments of the invention will become apparent from the dependent claims and the following description of preferred embodiments which refers to the appended figures. All combinations of the features disclosed, whether explicitly recited in the claims or not, are within the scope of the invention.

BRIEF DESCRIPTION OF THE DRAWINGS

Figure 1     is a schematic representation of a preferred embodiment of an optical exposure apparatus according to the invention comprising a preferred embodiment of the optical element module with a support structure according to the invention;

Figure 2     is a schematic view of a preferred embodiment of an optical element module that may be used in the optical exposure apparatus of Figure 1;

Figure 3     is a schematic view of a further preferred embodiment of an optical element module that may be used in the optical exposure apparatus of Figure 1;

Figure 4     is a schematic view of a further preferred embodiment of an optical element module that may be used in the optical exposure apparatus of Figure 1;

Figure 5     is a schematic view of a further preferred embodiment of an optical element module that may be used in the optical exposure apparatus of Figure 1.

DETAILED DESCRIPTION OF THE INVENTION

First embodiment

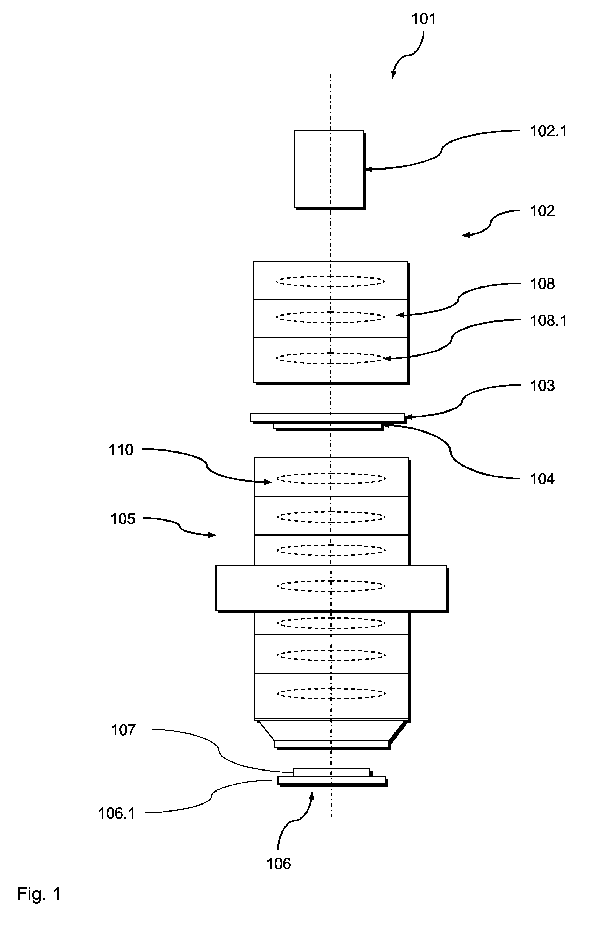

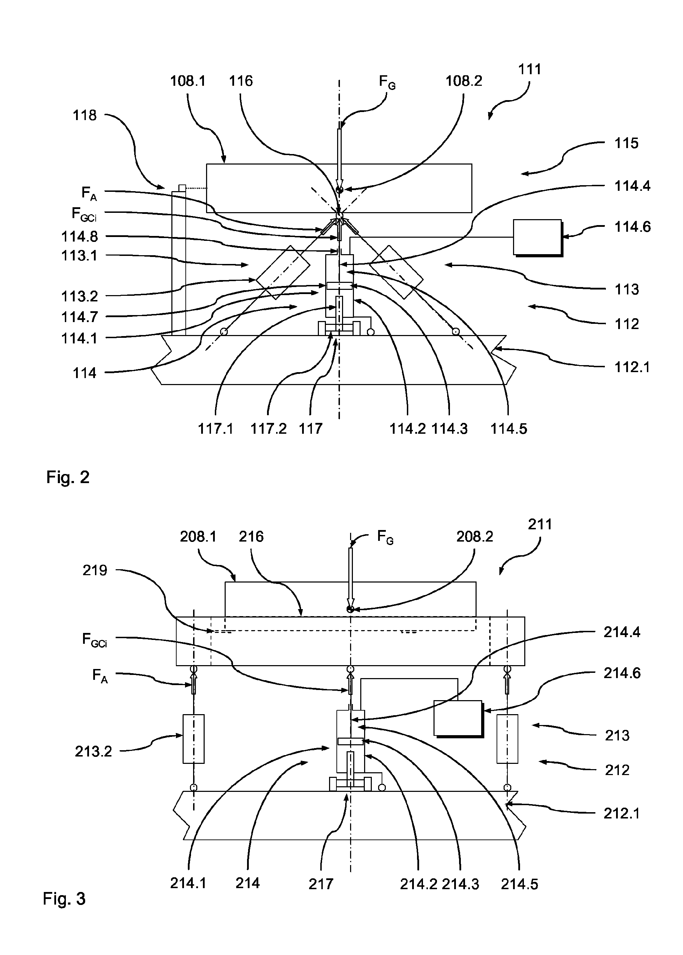

In the following, a first preferred embodiment of an optical exposure apparatus 101 according to the invention comprising an illumination system 102, a mask unit 103 holding a mask 104, an optical projection system 105 and a substrate unit 106 holding a substrate 107 will be described with reference to Figures 1 and 2.

The optical exposure apparatus is a microlithography apparatus 101 that is adapted to transfer an image of a pattern formed on the mask 104 onto the substrate 107. To this end, the illumination system 102 illuminates the mask 104 with exposure light. The optical projection system 105 projects the image of the pattern formed on the mask 104 onto the substrate 107, e.g. a wafer or the like.

The illumination system 102 comprises a light source 102.1 and a first optical element group 108 with a plurality of optical elements cooperating to define the beam of exposure light-schematically indicated by the double-dot-dashed contour 109 in Figure 1 - by which the mask 104 is illuminated. The optical projection system 104 comprises a second optical element group 110 with a plurality of optical elements cooperating to transfer an image of the pattern formed on the mask 104 onto the substrate 107.

The light source 102.1 provides light at a wavelength of 193 nm. Thus, the optical elements of the first optical element group 108 and the second optical element group 110 are refractive optical elements, i.e. lenses or the like. However, it will be appreciated that, with other embodiments of the invention operating at different wavelengths, in particular also in the so called EUV range (i.e. at a wavelength between 5 nm and 20 nm, typically about 13 nm), any types of optical elements, e.g. lenses, mirrors, gratings etc may be used alone or in an arbitrary combination.

During the exposure process, the wafer 107 is temporarily supported on a wafer table 106.1 forming part of the substrate unit 106. Depending on the working principle of the of the microlithography apparatus 101 (wafer stepper, wafer scanner or step-and-scan apparatus) the wafer 107 is moved at certain points in time relative to the optical projection system 105 to form a plurality of dies on the wafer 107. Once the entire wafer has been exposed, the wafer 107 is removed from the exposure area and the next wafer is placed in the exposure area.

Depending on the working principle of the microlithography apparatus 101, when switching from one die to the next die and/or from one wafer to the next wafer, the illumination setting of the illumination system 102 has to be rapidly changed. To this end, the position of an optical element in the form of the lens 108.1 of the first optical element group 108 has to be rapidly changed in order to achieve a high throughput of the microlithography apparatus 101.

As can be seen from Figure 2, the lens 108.1 - shown in a highly schematic manner- forms part of an optical element module 111. The optical element module 111 comprises a support structure 112 supporting the lens 108.1. The support structure 112, in turn, comprises a base structure 112.1, an actuator device 113 and a gravity compensation device 114.

The actuator device 113 comprises three actuator pairs 113.1 (only one of them being shown in Figure 1 for reasons of clarity). The actuator pairs 113.1 are evenly distributed at the circumference of the lens 108.1.

Each actuator pair 113.1 comprises two contactless actuators 113.2, such as voice coil motors (Lorentz actuators) or the like, each mechanically connected to the base structure 112.1 and the lens 108.1. The actuator device 113 serves to accelerate and, thus, to position the lens 108.1. To this end, it exerts a corresponding actuation force on the lens 108.1 as will be explained in greater detail below.

The gravity compensation device 114 comprises three gravity compensators 114.1 each of them being associated to one of the actuator pairs 113.1. Thus, the gravity compensators 114.1 as well are evenly distributed at the circumference of the lens 108.1. Each gravity compensator 114.1 is mechanically connected to the base structure 112.1 and the lens 108.1.

The gravity compensation device 114, in sum, exerts a total gravity compensation force $F_{GCt}$ which counteracts and fully compensates the gravitational force $F_G$ acting in the center of gravity (COG) 108.2 of the lens 108.1. Depending on the mass distribution of the lens 108.1 the individual gravity compensation forces $F_{GCi}$ exerted by the respective gravity compensator on the lens 108.1 are chosen such that, together, they fully compensate and balance the static forces and moments acting on the lens 108.1. It will be appreciated that, depending on the design of the actuators 113.2, eventually, this may also include forces and/or moments resulting from the weight of certain components of the actuator device 113 mechanically connected to the lens 108.1.

In other words, under static load conditions, the individual gravity compensation forces $F_{GCi}$ exerted by the individual gravity compensators 114.1 are selected such that the sum $\Sigma F_{COG}$ of all forces acting in the centre of gravity 108.2 and the sum $\Sigma M_{COG}$ of all moments acting in the centre of gravity 108.2 is zero, i.e.:

$$\sum F_{COG} = 0 , \qquad\qquad (1)$$

$$\sum M_{COG} = 0 . \qquad\qquad (2)$$

To this end, each gravity compensator 114.1 comprises a cylinder 114.2 and a piston 114.3 slidably mounted within the cylinder 114.2. A piston rod 114.4 guided in a suitable bush of the cylinder 114.2 mechanically connects the piston 114.3 to the lens 108.1. The cylinder 114.2 and the piston 114.3 define a negative pressure chamber 114.5. A negative pressure source 114.6 provides a suitable negative pressure NP within the negative pressure chamber 114.5.

This negative pressure provided by the negative pressure source 114.6 corresponds to a negative pressure setpoint value $NP_s$ which is selected such that, under static load conditions, the above equations (1) and (2) or are fulfilled, i.e. the required individual gravity compensation force $F_{GCi}$ as outlined above is exerted via the piston rod 114.4 on the lens 108.1.

The negative pressure source 114.6 comprises a simple pressure control which controls the negative pressure NP using the negative pressure setpoint value $NP_s$. In other words, the pressure control tries to maintain the negative pressure NP within the negative pressure chamber 114.5 as close as possible to the negative pressure setpoint value $NP_s$ at any time.

The pressure control may be fully integrated within the negative pressure source. However, it is also possible, for example, that a suitable pressure sensor of the pressure control is provided within or close to the cylinder 114.2 in order to reduce the reaction time of the control.

The actuator device 113 is preferably arranged to position the lens 108.1 in more than one degree of freedom (DOF), preferably in up to all six degrees of freedom (DOF). Depending on the positioning movement provided by the actuator device the location and/or orientation of the lens 108.1 may change such that the negative pressure setpoint value $NP_s$ has to be adjusted accordingly in order to achieve fulfilment of the above equations (1) and (2) under static load conditions for this location and/or orientation of the lens 108.1. Thus, a corresponding control of the negative pressure setpoint value $NP_s$ may be superimposed to the negative pressure control as outlined above.

It will be appreciated that, with certain embodiments of the invention, the control of the negative pressure setpoint value $NP_s$ may be performed as a function of an operational parameter of the actuator device 113 preferably being representative of the power taken up by the actuator device 113. This may be done in order to reduce the power consumed and, thus, the heat generated by the actuator device 113. For example, it is possible to adjust the negative pressure setpoint value $NP_s$ as a function of the electrical current taken by the actuator device 113.

The control of the negative pressure setpoint value $NP_s$ and, thus, of the negative pressure within the negative pressure chamber 114.5 is preferably provided at a low bandwidth, preferably at less than 5 Hz, such that the control does substantially not interfere with the dynamic position control of the lens 108.1 provided via the actuator device 113. Thus, the current taken and, consequently, the power consumed by the actuator device 113 may be reduced, both, under static load conditions as well as even under dynamic load conditions. This leads to an overall reduction of the heat generated within the actuator device 113 and, thus, within the optical system reducing thermally induced problems such as thermally induced degradation of imaging quality.

Thanks to the use of a negative pressure on the gravity compensation device 114 has very short reaction times and thus very good dynamic properties. This is due to the fact that, as already outlined above, only a rather low mass of working medium is to be conveyed within the negative pressure chamber 114.5, within the negative pressure lines connecting the negative pressure chamber 114.5 and the negative pressure source 114.6 and within the components of the negative pressure source 114.6 when positioning the optical element 108.1. Thus, a low inertia and a low internal friction on the working medium is to be dealt with leading to improved dynamic properties of the system.

It will be appreciated that the negative pressure NP is provided to be negative in relation to the pressure prevailing in the atmosphere 115 outside the negative pressure chamber 114.5 and surrounding the lens 108.1.

Thus, furthermore, the use of the negative pressure NP simply eliminates the contamination problem since there is no material transport through any sealing gap, such as the gap 114.7 formed between the cylinder 114.2 and the piston 114.3 and the gap 114.8 formed between the cylinder 114.2 and the piston rod 114.4, towards the evacuated atmosphere 115 surrounding the lens 108.1. On the contrary, if any, there is only material transport from the atmosphere 115 towards the negative pressure chamber 114.5.

However, it will be appreciated that, with other embodiments of the invention, it may be provided that there is no material flow between the negative pressure chamber and the atmosphere surrounding it, e.g. by providing suitable seals such as highly compliant membrane seals or the like. In this case the negative pressure within the negative pressure chamber may also be only negative in relation to an atmosphere prevailing within a further pressure chamber within the cylinder and lying on the opposite side of the piston. This further pressure chamber is then also sealed from the atmosphere surrounding the lens.

With the embodiment shown the lens 108.1 may be positioned over a range of more than 50 mm within less than 1 s. Furthermore, accelerations up to 100 m/s$^2$ may be achieved with lenses (or other optical elements) weighing 5 kg and more.

As can be seen from Figure 2, the gravity compensator 114.1 and the actuators 113.2 of the associated actuator pair 113.1 contact the lens 108.1 in a single interface 116 in such a manner that the gravity compensation force line of the individual gravity compensation force $F_{GCi}$ and the actuation force line of the respective actuation force $F_A$ intersect at the interface 116. Thus, an advantageous three-point support is provided to the lens 108.1.

As can be also seen from Figure 2, an end stop device 117 is associated to the respective gravity compensator 114.1. The end stop device 117 is formed by a tube 117.1 the upper end of which faces the piston 114.3 while its lower end is mechanically connected to the base of structure 112.1 via two membrane elements 117.2. In case of a failure of the negative pressure supply to the negative pressure chamber the piston 114.3 will move towards the upper end of the tube 117.1 due to the weight of the lens 108.1.

Once the lower face of the piston 114.3 engages the upper end of the tube 117.1 the membrane elements 117.2 gradually build up forces acting in the vertical direction in order to slow down and stop the movement of the lens 108.1. The tube 117.1 and the membrane elements may also build up such forces in a horizontal plane such that movement of the lens having a horizontal component may also be slowed down and stopped. Thus, in other words, the end stop device 117 may damp the forces acting on the lens 108.1 in case of a failure of its support and avoid damage to the lens 108.1 in this case.

It will be appreciated that the end stop device may be of any other suitable design in order to fulfill this task. In particular, any other resilient and/or damping support may be selected for the part engaging the piston 114.3. Furthermore, it will be appreciated that the piston and/or the end stop device may have any suitable design which guarantees a proper force transmitting engagement in case of their contact upon a failure.

Finally, as can be seen from Figure 2, the base structure 112.1 also forms support for a metrology arrangement 118 capturing the relative position of the lens 108.1 in relation to the base structure 112.1. This relative position of the lens 108.1 is then used to control the active positioning of the lens 108.1 via the actuator device 113.

It will be appreciated that the base structure 112.1 may be supported on a ground structure for a further base structure - not shown in Figure 2 - in a vibration isolated manner in order to avoid introduction of vibrations into the optical system.

It will be further appreciated that, in case the optical element 108.1 is a mirror or another optical element that is not optically used in its central area, instead of the distribution with three gravity compensation devices 114 and three actuator pairs 113.1 as described above, there may also be provided a single, centrally located gravity compensation device 114 and a plurality of actuators 113.2 associated thereto.

The gravity compensator 114.1 is then located such that the gravity compensation force line of its gravity compensation force $F_{GCi}$ extends through the center of gravity 108.2 of the optical element 108.1. The gravity compensation force $F_{GCi}$ then in itself fully compensates the gravitational force $F_G$ acting on the optical element 108.1. The interface 116 then it is a rigid interface that is capable of transmitting forces and moments of the optical element 108.1 in up to six degrees of freedom (DOF).

Second embodiment

In the following, a second preferred embodiment of an optical element module 211 which may replace the optical element module 111 in the exposure apparatus 101 of Figure 1 will be described with reference to Figures 1 and 3.

This embodiment, in its basic design and functionality, largely corresponds to the embodiment of Figure 2 such that it is here at mainly referred to the differences only. As a consequence, like or identical parts have been given the same reference number raised by 100.

As can be seen from Figure 3, the lens 208.1 is supported by a support structure 212 comprising a base structure 212.1, an actuator device 213 and a gravity compensation device 214 and an interface device in the form of a support ring 216. The lens 208.1 is connected to the support ring 216 via three or more leaf springs 219 evenly distributed at the circumference of the lens 208.1.

The actuator device 213 comprises two contactless actuators 213.2 similar to the ones described above in the context of the first embodiment. Each actuator 213.2 is mechanically connected to the base structure 212.1 and the support ring 216. The actuator devices 213 serve to accelerate and, thus, to position the lens 208.1 in one degree of freedom (DOF) while suitable guide mechanisms - not shown in Figure 3 - restrict the movement of the lens 208.1 in the five other degrees of freedom (DOF). The gravity compensation device 214 comprises two gravity compensators 214.1. Each gravity compensator 214.1 is mechanically connected to the base structure 212.1 and the lens 208.1.

The actuators 213.2 and the gravity compensators 214.1 are evenly distributed at the circumference of the lens 208.1. The distribution is such that the gravity compensation force lines of the individual gravity compensation forces $F_{GCi}$ exerted by the respective gravity compensator on the lens 208.1 lie in a common plane with the center of gravity (COG) 208.2 of the lens 208.1. Furthermore, the distribution is such that the actuator force lines of the individual actuator forces $F_A$ exerted by the respective actuator on the lens 208.1 lie in a common plane with the center of gravity (COG) 208.2 as well.

Furthermore, the gravity compensation force lines and the actuator force lines are substantially parallel to each other and to the force line of the gravitational force $F_G$ acting on the lens 208.1.

The gravity compensation device 214, in sum, exerts a total gravity compensation force $F_{GCT}$ which counteracts and fully compensates the gravitational force $F_G$ acting in the center of gravity (COG) 208.2 of the lens 208.1. Depending on the mass distribution of the lens 208.1 the individual gravity compensation forces $F_{GCi}$ exerted by the respective gravity compensator on the lens 208.1 are chosen such that, together, they fully compensate and balance the static forces and moments acting on the lens 208.1 and the support ring 216, i.e. such that the equations (1) and (2) are fulfilled. It will be appreciated that, depending on the design of the actuators 213.2, eventually, this may also include forces and/or moments resulting from the weight of certain components of the actuator device 213 mechanically connected to the lens 208.1.

Each gravity compensator 214.1 again comprises a cylinder 214.2 and a piston 214.3 slidably mounted within the cylinder 214.2. A piston rod 214.4 guided in a suitable bush of the cylinder 214.2 mechanically connects the piston 214.3 to the lens 208.1. The cylinder 214.2 and the piston 214.3 define a negative pressure chamber 214.5. Again a negative pressure source 214.6 provides a suitable negative pressure NP within the negative pressure chamber 214.5. This negative pressure is controlled and has been explained above the context of the first embodiment.

Again, as can be also seen from Figure 3, an end stop device 217 identical to the end stop device 117 of Figure 2 is associated to the respective gravity compensator 214.1.

It will be appreciated that the base structure 212 .1 may be supported on a ground structure for a further base structure - not shown in Figure 3 - in a vibration isolated manner in order to avoid introduction of vibrations into the optical system.

Third embodiment

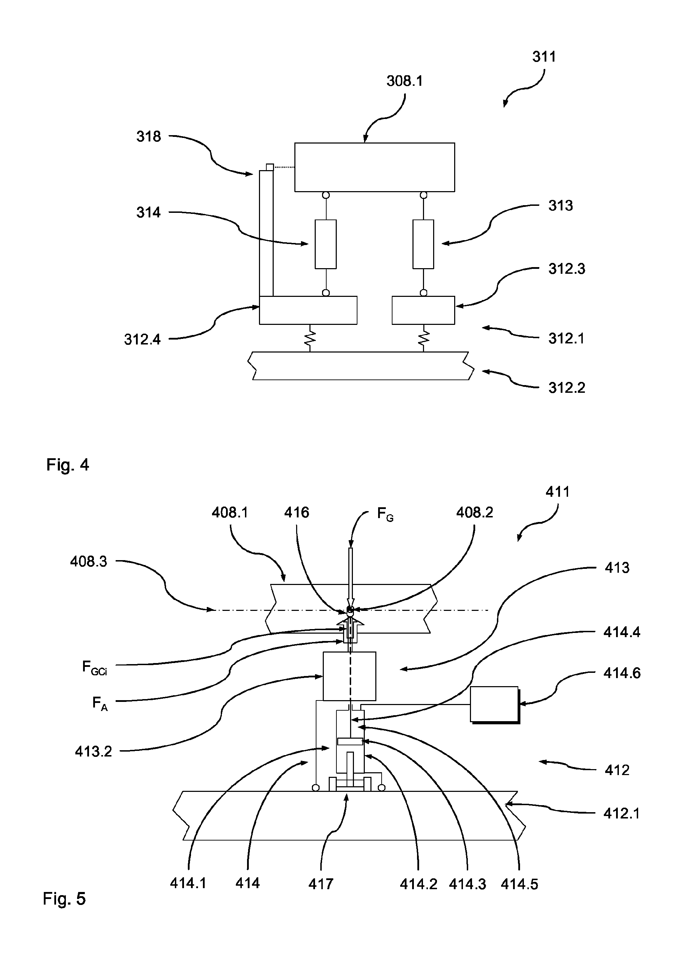

In the following, a third preferred embodiment of an optical element module 311 which may replace the optical element module 111 in the exposure apparatus 101 of Figure 1 will be described with reference to Figure 4.

This embodiment, in its basic design and functionality, largely corresponds to the embodiment of Figure 2 such that it is here at mainly referred to the differences only. As a consequence, like or identical parts have been given the same reference number raised by 200.

As can be seen from - highly schematic - Figure 4, the lens 308.1 is supported by a support structure 312 comprising a base structure 312.1, an actuator device 313 and a gravity compensation device 314.

Other than with the previous embodiments, the base structure 312.1 comprises a first base structure part 312.2 on which a second base structure part 312.3 and a third base structure part 312.4 are each supported in a vibration isolated manner. While the second base structure part 312.3 supports the actuator device 313, the third base structure part 312.4 supports the gravity compensating device 314 and the metrology arrangement 318. This has the advantage that the gravity compensating device 314 and the metrology arrangement 318 are dynamically decoupled from actuator device 313 reducing the overall vibration disturbances introduced into the system.

It will be appreciated that the gravity compensating device and the actuator device may be of any suitable design. In particular, they may be of the design as it has been described above in the context of the first and second embodiment.

Fourth embodiment

In the following, a fourth preferred embodiment of an optical element module 411 which may replace the optical element module 111 in the exposure apparatus 101 of Figure 1 will be described with reference to Figure 5.

This embodiment, in its basic design and functionality, largely corresponds to the embodiment of Figure 2 such that it is here at mainly referred to the differences only. As a consequence, like or identical parts have been given the same reference number raised by 300.

As can be seen from Figure 5, the lens 408.1 is supported by a support structure 412 comprising a base structure 412.1, an actuator device 413 and a gravity compensation device 414.

The actuator device 413 comprises a plurality of contactless actuators 413.2 similar to the ones described above in the context of the first embodiment. Each actuator 413.2 is mechanically connected to the base structure 412.1 and the lens 408.1. The actuator device 413 serves to accelerate and, thus, to position the lens 408.1. The gravity compensation device 414 comprises a plurality of gravity compensators 414.1. Each gravity compensator 414.1 is associated to an actuator 413.2 and mechanically connected to the base structure 412.1 and the lens 408.1.

Each actuator 413.2 and its associated gravity compensator 414.1 form a support unit. Furthermore, the actuator 413.2 and its associated gravity compensator 414.1 are arranged such that the gravity compensation force lines and the actuator force lines are substantially collinear to each other and parallel to the force line of the gravitational force $F_G$ acting on the lens 408.1. To this end, the piston rod 414.4 of the gravity compensator 414.1 extends through a tube shaped actuator rod of the actuator 413.2. By this means, a very compact arrangement may be achieved.

The actuator 413.2 and the associated gravity compensator 414.11 connected to the lens 408.1 and a common interface 416 located close to the neutral plane of deformation 408.3 of the lens 408.1. Herewith an advantageous introduction of loads into the lens 408.1 is achieved.

A suitable number of the support units formed by an actuator 413.2 and its associated gravity compensator 414.1 are evenly distributed at the circumference of the lens 408.1. The gravity compensation device 414, in sum, exerts a total gravity compensation force $F_{GCt}$ which counteracts and fully compensates the gravitational force $F_G$ acting in the center of gravity (COG) 408.2 of the lens 408.1. Depending on the mass distribution of the lens 408.1 the individual gravity compensation forces $F_{GCi}$ exerted by the respective gravity compensator on the lens 408.1 are chosen such that, together, they fully compensate and balance the static forces and moments acting on the lens 408.1, i.e. such that the equations (1) and (2) are fulfilled. It will be appreciated that, depending on the design of the actuators 413.2, eventually, this may also include forces and/or moments resulting from the weight of certain components of the actuator device 413 mechanically connected to the lens 408.1.

Each gravity compensator 414.1 again comprises a cylinder 414.2 and a piston 414.3 slidably mounted within the cylinder 414.2. A piston rod 414.4 guided in a suitable bush of the cylinder 414.2 mechanically connects the piston 414.3 to the lens 408.1. The cylinder 414.2 and the piston 414.3 define a negative pressure chamber 414.5. Again a negative pressure source 414.6 provides a suitable negative pressure NP within the negative pressure chamber 414.5. This negative pressure is controlled and has been explained above the context of the first embodiment.

Again, as can be also seen from Figure 3, an end stop device 417 identical to the end stop device 117 of Figure 2 is associated to the respective gravity compensator 414.1.

In the foregoing, the invention has been described in the context of embodiments operating at a wavelength of 193 nm mainly with refractive optical elements. However, it will be appreciated that, with other embodiments of the invention working at different wavelengths, in particular also in the EUV range, the use of other types of optical elements (e.g. mirrors, gratings) is possible as well.

Furthermore, the invention has been described in the context of contactless actuator devices such as voice coil motors (Lorentz actuators). However, it will be appreciated that, with other embodiments of the invention, it is also possible to apply the invention in a configuration where any other type of actuator is used for adjusting the position of the respective optical element.

Furthermore, the invention has been described in the context of adjusting the position of an optical element in a rather large positioning range which is achievable under satisfying dynamic conditions thanks to the use of the negative pressure. However, it will be appreciated that, with smaller positioning ranges as they are often required for the position adjustment of optical elements in the optical projection system, it is also possible to realize the geometric configurations described above with mechanical and/or magnetic gravity compensators as they have been described initially.

Furthermore, the invention has been described in the context of adjusting the position of an optical element of an illumination system. However, it will be appreciated that, with other embodiments of the invention, it is also possible to apply the invention to an optical element of the optical projection system or any other part of an optical exposure apparatus.

In the foregoing, the invention has been described only in the context of microlithography applications. However, it will be appreciated that the invention may be used in the context of any other imaging process.

## Claims

1. An optical element module comprising:

   - an optical element and
   - a support structure supporting said optical element;
   - said support structure comprising an actuator device and a gravity compensation device;
   - said actuator device being mechanically connected to said optical element
   - said actuator device being adapted to exert an actuation force on said optical element, said actuation force accelerating said optical element;
   - said gravity compensation device comprising a gravity compensator;
   - said gravity compensator being mechanically connected to said optical element
   - said gravity compensator being adapted to exert a gravity compensation force on said optical element when a negative pressure is acting within said gravity compensator;
   - said gravity compensation force counteracting at least a part of the gravitational force acting on said optical element.

2. The optical element module according to claim 1, wherein said gravity compensation force substantially compensates the gravitational force acting on said optical element.

3. The optical element module according to claim 1, wherein

   - said gravity compensation device comprises a negative pressure source,
   - said negative pressure source generating said negative pressure within a working medium acting within said gravity compensator to generate said gravity compensation force.

4. The optical element module according to claim 3, wherein said working medium is a gaseous medium.

**5.** The optical element module according to claim 3, wherein

- said gravity compensation device comprises a negative pressure control device,
- said negative pressure control device controlling said negative pressure source such that said negative pressure is maintained substantially constant during actuation of said optical element via said actuator device.

**6.** The optical element module according to claim 1, wherein

- said gravity compensator comprises a cylinder element and a piston element arranged within said cylinder element;
- said cylinder element and said piston element being movable relative to each other and defining a negative pressure chamber;
- one of said piston element and said cylinder element being adapted to be mechanically connected to said optical element and to exert at least a part of said gravity compensation force on said optical element when said negative pressure is acting within said negative pressure chamber.

**7.** The optical element module according to claim 6, wherein

- a gap is formed between said cylinder element and said piston element,
- said gap allowing a slight flow of a medium forming an atmosphere external to said negative pressure chamber into said negative pressure chamber when said negative pressure prevails within said negative pressure chamber.

**8.** The optical element module according to claim 6, wherein

- a gap is formed between said cylinder element and said piston element,
- said gap being sealed by a sealing device.

**9.** The optical element module according to claim 1, wherein

- said gravity compensator is adapted to follow a travel of said optical element at a substantially constant gravity compensation force,
- said travel being at least 10 mm long, preferably at least 50 mm long.

**10.** The optical element module according to claim 8, wherein said gravity compensator is adapted to follow said travel of said optical element at a substantially constant gravity compensation force within less than 2 s, preferably less than 1 s.

**11.** The optical element module according to claim 1, wherein

- said gravity compensator is adapted to exert at least a part of said gravity compensation force on said optical element along a gravity compensation force line and
- said actuator device comprises an actuator adapted to exert said actuation force on said optical element along an actuation force line;
- said gravity compensation force line and said actuation force line intersecting at an intersection point.

**12.** The optical element module according to claim 11, wherein said intersection point is located at least close to a mechanical interface where at least one of said gravity compensator and said actuator is connected to said optical element.

**13.** The optical element module according to claim 1, wherein

- said gravity compensator is adapted to exert at least a part of said gravity compensation force on said optical element along a gravity compensation force line and
- said actuator device comprises an actuator adapted to exert said actuation force on said optical element along an actuation force line;
- said gravity compensation force line and said actuation force line being substantially parallel.

**14.** The optical element module according to claim 13, wherein said gravity compensation force line and said actuation force line are substantially collinear.

**15.** The optical element module according to claim 1, wherein

- an interface device is provided;
- at least one of said gravity compensation device and said actuator device being mechanically connected to said interface device;
- said interface device being mechanically connected to said optical element.

**16.** The optical element module according to claim 1, wherein

- said optical element has an outer circumference,
- the components of at least one of said gravity compensation device and said actuator device being substantially evenly distributed that said outer circumference.

**17.** The optical element module according to claim 1, wherein

- said optical element has a center of gravity,
- said gravity compensation device being adapted to exert said gravity compensation force on said optical element along a gravity compensation force line and
- said actuator device being adapted to exert said actuation force on said optical element along an actuation force line;
- said actuator device and said gravity compensation device being arranged such that at least one of said gravity compensation force line and said actuation force line extends through said center of gravity of said optical element.

**18.** The optical element module according to claim 1, wherein said actuator device comprises at least one Lorentz actuator.

**19.** The optical element module according to claim 1, wherein

- an end stop device is provided;
- said end stop device being adapted to limit gravity induced movement of said optical element in case of a failure of said gravity compensation device.

**20.** The optical element module according to claim 19, wherein said end stop device is adapted to damp reaction forces acting on said optical element when limiting gravity induced movement of said optical element in case of a failure of said gravity compensation device.

**21.** The optical element module according to claim 19, wherein said end stop device is associated to at least one of said gravity compensation device and said actuator device.

**22.** The optical element module according to claim 1, wherein

- a base structure is provided;
- said gravity compensation device and said actuator device being supported on said base structure in a vibration isolated manner.

**23.** The optical element module according to claim 22, wherein

- said gravity compensation device is supported on a first support device, said first support device being supported on said base structure in a vibration isolated manner, and
- said actuator device is supported on a second support device, said second support device being supported on said base structure in a vibration isolated manner.

**24.** The optical element module according to claim 1, wherein said optical element is an optical element of a microlithography device.

**25.** The optical element module according to claim 24, wherein said optical element is an optical element of an illumination device of said microlithography device.

**26.** An optical exposure apparatus for transferring an image of a pattern formed on a mask onto a substrate comprising:

- an illumination system adapted to provide light of a light path;
- a mask unit located within said light path and adapted to receive said mask;
- a substrate unit located at an end of said light path and adapted to receive said substrate;
- an optical projection system located within said light path between said mask location and said substrate location and adapted to transfer an image of said pattern onto said substrate;
- at least one of said illumination system and said optical projection system comprising an optical element module;
- said optical element module comprising an optical element and a support structure supporting said optical element;
- said support structure comprising an actuator device and a gravity compensation device;
- said actuator device being mechanically connected to said optical element
- said actuator device being adapted to exert an actuation force on said optical element, said actuation force accelerating said optical element;
- said gravity compensation device comprising a gravity compensator;
- said gravity compensator being mechanically connected to said optical element
- said gravity compensator being adapted to exert a gravity compensation force on said optical element when a negative pressure is acting within said gravity compensator;
- said gravity compensation force counteracting at least a part of the gravitational force acting on said optical element.

**27.** A support structure for supporting an optical element comprising:

- an actuator device and
- a gravity compensation device;
- said actuator device being adapted to be mechanically connected to said optical element and to exert an actuation force on said optical element, said actuation force accelerating said optical element;
- said gravity compensation device comprising a gravity compensator;
- said gravity compensator being adapted to be mechanically connected to said optical element and to exert a gravity compensation force on said optical element when a negative pressure is acting within said gravity compensator;
- said gravity compensation force counteracting at least a part of the gravitational force acting on said optical element.

**28.** The support structure according to claim 27, wherein

- said gravity compensator comprises a cylinder element and a piston element arranged within said cylinder element;
- said cylinder element and said piston element being movable relative to each other and defining a negative pressure chamber;
- one of said piston element and said cylinder element being adapted to be mechanically connected to said optical element and to exert at least a part of said gravity compensation force on said optical element when said negative pressure is acting within said negative pressure chamber.

**29.** The support structure according to claim 28, wherein

- a gap is formed between said cylinder element and said piston element,
- said gap allowing a slight flow of a medium forming an atmosphere external to said negative pressure chamber into said negative pressure chamber when said negative pressure prevails within said negative pressure chamber.

**30.** The support structure according to claim 27, wherein

- said gravity compensator is adapted to follow a travel of said optical element at a substantially constant gravity compensation force,

- said travel being at least 10 mm long, preferably at least 50 mm long.

**31.** The support structure according to claim 30, wherein said gravity compensator is adapted to follow said travel of said optical element at a substantially constant gravity compensation force within less than 2 s, preferably less than 1 s.

**32.** A method of supporting an optical element comprising:

- providing an optical element and a gravity compensation device,
- exerting a gravity compensation force on said optical element via said gravity compensation device, said gravity compensation force counteracting at least a part of the gravitational force acting on said optical element;
- said the exerting said gravity compensation force comprises generating said gravity compensation force using a negative pressure.

**33.** The method according to claim 32, wherein said gravity compensation force substantially compensates the gravitational force acting on said optical element.

**34.** The method according to claim 32, wherein an actuation force is exerted on said optical element via an actuator device, said actuation force accelerating said optical element;

**35.** The method according to claim 34, wherein said negative pressure is controlled such that said negative pressure is maintained substantially constant during actuation of said optical element via said actuator device.

**36.** The method according to claim 34, wherein said actuator device comprises at least one Lorentz actuator.

**37.** The method according to claim 32, wherein

- said gravity compensation device comprises a cylinder element and a piston element arranged within said cylinder element, said cylinder element and said piston element being movable relative to each other and defining a negative pressure chamber;
- one of said piston element and said cylinder element is mechanically connected to said optical element;
- said exerting said gravity compensation force comprises generating said negative pressure within said negative pressure chamber.

**38.** The method according to claim 32, wherein

- generating a travel of said optical element via an actuator device,
- said travel being at least 10 mm long, preferably at least 50 mm long;
- maintaining said gravity compensation force substantially constant during said generating said travel of said optical element.

**39.** The method according to claim 38, wherein said travel is generated within less than 2 s, preferably less than 1 s.

**40.** The method according to claim 32, wherein

- at least a part of said gravity compensation force is exerted on said optical element along a gravity compensation force line and
- an actuation force accelerating said optical element is exerted along an actuation force line on said optical element via an actuator device;
- said gravity compensation force line and said actuation force line intersecting at an intersection point.

**41.** The method according to claim 32, wherein

- at least a part of said gravity compensation force is exerted on said optical element along a gravity compensation force line and
- an actuation force accelerating said optical element is exerted along an actuation force line on said optical element via an actuator device;
- said gravity compensation force line and said actuation force line being substantially parallel.

**42.** The method according to claim 41, wherein said gravity compensation force line and said actuation force line are substantially collinear.

**43.** The method according to claim 32, wherein

- an interface device is provided;
- said gravity compensation force being exerted on said optical element via said interface device.

**44.** The method according to claim 32, wherein

- said optical element has a center of gravity and
- said gravity compensation force is exerted on said optical element along a gravity compensation force line;
- said gravity compensation force line extending through said center of gravity of said optical element.

**45.** The method according to claim 32, wherein, in case of a failure of said gravity compensation device, gravity induced movement of said optical element is limited via an end stop device.

**46.** The method according to claim 45, wherein said end stop device is damping reaction forces acting on said optical element when limiting gravity induced movement of said optical element in case of a failure of said gravity compensation device.

**47.** The method according to claim 34, wherein

- a base structure is provided;
- said gravity compensation device and said actuator device being supported on said base structure in a vibration isolated manner.

**48.** The method according to claim 47, wherein

- said gravity compensation device is supported on a first support device, said first support device being supported on said base structure in a vibration isolated manner, and
- said actuator device is supported on a second support device, said second support device being supported on said base structure in a vibration isolated manner.

**49.** The method according to claim 32, wherein said optical element is an optical element of a microlithography device.

**50.** The method according to claim 49, wherein said optical element is an optical element of an illumination device of said microlithography device.

**51.** The method according to claim 32, wherein said negative pressure is continuously adjusted at a bandwidth of less than 5 Hz.

**52.** The method according to claim 32, wherein

- an actuation force is exerted on said optical element via an actuator device, said actuation force accelerating said optical element;
- said negative pressure is continuously adjusted as a function of an operational parameter of said actuator device for reducing the power consumed by said actuator device.

**53.** The method according to claim 52, wherein

- said actuator device comprises an electrical actuator and
- said operational parameter is a current taken by said electrical actuator.

Fig. 1

Fig. 2

Fig. 3

Fig. 4

Fig. 5

**EP 1 882 983 A1**

**European Patent Office** 　**EUROPEAN SEARCH REPORT**

Application Number

EP 06 11 7813

| | DOCUMENTS CONSIDERED TO BE RELEVANT | | |
|---|---|---|---|
| Category | Citation of document with indication, where appropriate, of relevant passages | Relevant to claim | CLASSIFICATION OF THE APPLICATION (IPC) |
| D,A | US 2004/001188 A1 (JANSSEN ERIC W A [NL] ET AL) 1 January 2004 (2004-01-01) * paragraphs [0045] - [0052]; figure 2 * ----- | 1-53 | INV. G03F7/20 |
| D,A | US 2004/179192 A1 (MIZUNO MAKOTO [JP] ET AL) 16 September 2004 (2004-09-16) * paragraphs [0069] - [0090]; figures 1-5 * ----- | 1-53 | |
| A | WO 2005/083487 A (ZEISS CARL SMT AG [DE]; STOMMEN BERNARD [NL]; SOEMERS HERMAN [NL]; VAN) 9 September 2005 (2005-09-09) * page 4, line 21 - page 5, line 3; figures 1-3 * ----- | 1-53 | |
| A | EP 0 694 798 A (EASTMAN KODAK CO [US]) 31 January 1996 (1996-01-31) * column 4, lines 26-34; figure 2 * ----- | 1,6-8, 26-29, 32,37 | |
| X | US 6 885 436 B1 (BERMAN MICHAEL J [US] ET AL) 26 April 2005 (2005-04-26) * column 8, lines 20-52; figure 4 * ----- | 32-36, 38-42, 49,51 | TECHNICAL FIELDS SEARCHED (IPC) G03F H01L G02B F15B |

The present search report has been drawn up for all claims

| Place of search | Date of completion of the search | Examiner |
|---|---|---|
| Munich | 9 November 2007 | Weckesser, Jens |

EPO FORM 1503 03.82 (P04C01)

**ANNEX TO THE EUROPEAN SEARCH REPORT
ON EUROPEAN PATENT APPLICATION NO.**

EP 06 11 7813

This annex lists the patent family members relating to the patent documents cited in the above-mentioned European search report.
The members are as contained in the European Patent Office EDP file on
The European Patent Office is in no way liable for these particulars which are merely given for the purpose of information.

09-11-2007

| Patent document cited in search report | | | Publication date | Patent family member(s) | | | Publication date |
|---|---|---|---|---|---|---|---|
| US 2004001188 | A1 | | 01-01-2004 | NONE | | | |
| US 2004179192 | A1 | | 16-09-2004 | EP | 1457834 | A2 | 15-09-2004 |
| WO 2005083487 | A | | 09-09-2005 | JP | 2007524129 | T | 23-08-2007 |
| EP 0694798 | A | | 31-01-1996 | JP | 8057785 | A | 05-03-1996 |
| | | | | US | 5572785 | A | 12-11-1996 |
| US 6885436 | B1 | | 26-04-2005 | US | 7098996 | B1 | 29-08-2006 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20040179192 A1, Mizuno
- US 20040212794 A1, Mizuno
- US 20030052284 A1, Hol
- US 20050002008 A1, De Weerdt
- US 20040001188 A1, Janssen